# EUROPEAN PATENT SPECIFICATION

(11) **EP 3 654 373 B1**
(45) Date of publication and mention of the grant of the patent: **06.01.2021**
(21) Application number: 18206985.6
(22) Date of filing: 19.11.2018
(51) Int. Cl.: H01L 25/07, H01L 23/495

(54) **MULTI-CHIP-PACKAGE**
MEHR-CHIP GEHÄUSE
BOITIER MULTI-PUCES

(43) Date of publication of application: 20.05.2020
(73) Proprietor: Infineon Technologies AG, 85579 Neubiberg (DE)
(72) Inventor: OTREMBA, Ralf, 87600 Kaufbeuren (DE)
(74) Representative: Maikowski & Ninnemann Patentanwälte Partnerschaft mbB

(56) References cited:
- EP-A1- 2 858 110
- JP-A- H08 340 082
- JP-A- 2004 022 960
- US-A1- 2001 050 421
- US-A1- 2018 061 745

## Description

### TECHNICAL FIELD

This specification refers to embodiments of a package enclosing a plurality of power semiconductor chips and to embodiments of system for supplying a load current to a load, said system including a package enclosing a plurality of power semiconductor chips. In particular, this specification refers to embodiments of a Surface-Mount Device (SMD) package with Top Side Cooling, said package enclosing a plurality of power semiconductor chips, and to embodiments of a system including such package.

### BACKGROUND

Many functions of modern devices in automotive, consumer and industrial applications, such as converting electrical energy and driving an electric motor or an electric machine, rely on power semiconductor devices.

For example, Insulated Gate Bipolar Transistors (IGBTs), Metal Oxide Semiconductor Field Effect Transistors (MOSFETs) and diodes, to name a few, have been used for various applications including, but not limited to switches in power supplies and power converters.

A power semiconductor device usually comprises one or more power semiconductor chips, each configured to conduct a load current along a load current path between two load terminals of the respective chip. Further, the load current path may be controlled, e.g., by means of an insulated electrode, sometimes referred to as gate electrode. For example, upon receiving a corresponding control signal from, e.g., a driver, the control electrode may set the power semiconductor chip in one of a conducting state and a blocking state.

After the power semiconductor chip has been manufactured, it is usually installed within in a package, e.g., in a manner that allows the package with the chip(s) to be arranged within an application, e.g., in a power converter or power supply system, e.g., such that the chip(s) may be coupled to a carrier, e.g., a printed circuit board (PCB), via the package.

To this end, a technology commonly referred to as surface-mount technology (SMT) is known, wherein this notion may generally refer to producing electronic circuits in which the components are mounted or placed directly onto the surface of a PCB. Such a component is hence referred to as surface-mount-device (SMD) component.

Another mounting configuration is the so-called through-hole technology, e.g., a construction method of fitting components with wire leads into holes in a circuit board.

Generally, an SMD component can be smaller than its through-hole counterpart. Nevertheless, both technologies are still used nowadays.

A package may have short pins or leads of various styles, flat contacts (also known as "terminal pads"), a matrix of solder balls (e.g., a so-called Ball Grid Array (BGA)), and/or terminations on the package body of the component.

Exemplary configurations of an SMD package are known from documents DE 10 2015 101 674 A1 and DE 10 2015 120 396 A1. Each of these SMD packages encloses a power semiconductor chip and has a package body with a package top side, a package footprint side and package sidewalls, wherein the package sidewalls extend from the package footprint side to the package top side. The chip has a first load terminal and a second load terminal and is configured to block a blocking voltage applied between said load terminals. The packages each further comprise a lead frame structure configured to electrically and mechanically couple the package to a support with the package footprint side facing to the support. The lead frame structure comprises outside terminals extending out of the package sidewall and electrically connected with the first load terminal of the chip. Further, each of the packages comprise a top layer arranged at the package top side and being electrically connected with the second load terminal of the chip.

Accordingly, each of these SMD packages known from documents DE 10 2015 101 674 A1 and DE 10 2015 120 396 A1 may exhibit a package top side that faces away from the support and that is equipped with a top layer to which a heat dissipation device, e.g., a heat sink, may be mounted. Thereby, heat can be removed away from the package that encloses the chip. Such kind of packages may hence be referred to as a SMD-Top Side Cooling (SMD-TSC) packages.

The primary function of the components fulfilling heat dissipation is to remove heat away from the package body. To this end, it is for example known to couple a heat sink to the top layer, e.g., by means of an intermediate component, such as a heat spreader. The heat sink may be electrically insulated from the top layer.

Of course, the dimension and/or configuration of the means for dissipating heat of the package correlate with the heat generated by the chip(s) that operate(s) within the package, i.e., the losses generated by the chip(s) during operation. E.g., such losses occur during switching event (so-called switching losses) and during load current conduction (so-called on-state losses or static losses). Losses that may occur during constant off-state (blocking state) of the chip(s) are rather significantly lower than the switching losses and the on-state losses.

It goes without saying that low power losses caused by power semiconductor chips are generally desirable. If the power losses are small, comparatively little heat as to be dissipated and, hence, the dimension and/or configuration of the means for dissipating heat of the package can be small and/or, respectively, simple. In contrast, high amount of losses, i.e., high amount of heat require large/complex heat dissipating means.

US 2001/0050421 describes an electrode wiring structure which shall realize a smaller semiconductor apparatus as a power semiconductor module with the current path set as shortest as possible. The semiconductor apparatus includes: a plurality of semiconductor devices mounted in one array or more on a substrate; a main current electrode mounted along the array(s) of the semiconductor devices, and commonly connected to each of the plurality of semiconductor devices through the substrate by being connected to the substrate through a plurality of wires; an insulated base mounted on the main current electrode, and covering the connection area of the wires connecting the main current electrode; and a drive electrode mounted on the base, and commonly connected to each of the semiconductor devices.

### SUMMARY

The subject-matter of the independent claim is presented. Features of some of the herein exemplarily described embodiments are defined in the dependent claims.

Certain aspects of the present specification are related to embodiments of a package that includes at least two separate power semiconductor chips connected in parallel to each other, thereby achieving a package with a comparatively small total on-state resistance (Rₒₙ) and, correspondingly, with comparatively small static losses.

Exemplary embodiments of the package disclosed herein are surface-mount device (SMD) packages, e.g., SMD-TSC packages. Other embodiments of the packages are configured in accordance with the through-hole technology, e.g., packages in accordance with other embodiments are based on the SIP (single in-line package) or DIP (dual in-line package) or DIPP (dual in-line pin package) technology. Further exemplary embodiments of the package disclosed herein are leadless packages.

The package comprises: a package body with a package top side, a package footprint side and package sidewalls, the package sidewalls extending from the package footprint side to the package top side; a plurality of power semiconductor chips electrically connected in parallel to each other, each power semiconductor chip having a first load terminal and a second load terminal and being configured to block a blocking voltage applied between said load terminals and to conduct a chip load current between said load terminals; a lead frame structure configured to electrically and mechanically couple the package to a carrier with the package footprint side facing to the carrier, the lead frame structure comprising a first load terminal bar and at least one first outside terminal, the at least one first outside terminal extending out of the package body for interfacing with the carrier and being electrically connected with each of the first load terminals of the plurality of power semiconductor chips by means of the first load terminal bar. The plurality of power semiconductor chips are arranged horizontally adjacent to each other along a first lateral direction in the package body. The first load terminal bar extends along the first lateral direction so as to subsequently establish electrical contact with the first load terminals of the power semiconductor chips.

A system for supplying a load current to a load is presented. The system comprises a power supply, a power supply path for coupling the power supply to the load; and a system main switch in the power supply path, wherein the system main switch comprises one or more packages in accordance with the first embodiment, wherein the one or more packages are configured to conduct the load current.

Furthermore, a method of processing a package is provided. The method includes:
- Providing a package body with a package top side, a package footprint side and package sidewalls, the package sidewalls extending from the package footprint side to the package top side;
- Arranging a plurality of power semiconductor chips in the package body and electrically connecting the chips in parallel to each other, each power semiconductor chip having a first load terminal and a second load terminal and being configured to block a blocking voltage applied between said load terminals and to conduct a chip load current between said load terminals;
- Providing a lead frame structure configured to electrically and mechanically couple the package to a carrier with the package footprint side facing to the carrier, the lead frame structure comprising a first load terminal bar and at least one first outside terminal, the at least one first outside terminal extending out of the package body for interfacing with the carrier and being electrically connected with each of the first load terminals of the plurality of power semiconductor chips by means of the first load terminal bar;
- Processing the package such that the plurality of power semiconductor chips are arranged horizontally adjacent to each other along a first lateral direction in the package body, and such that the first load terminal bar extends along the first lateral direction so as to subsequently establish electrical contact with the first load terminals of the power semiconductor chips.

### BRIEF DESCRIPTION OF THE DRAWINGS

The parts in the figures are not necessarily to scale, instead emphasis is being placed upon illustrating principles of the invention. Moreover, in the figures reference numerals may designate corresponding parts. In the drawings:

- Fig. 1: schematically and exemplarily illustrates a section of a perspective projection of a package in accordance with one or more embodiments;
- Fig. 2: schematically and exemplarily illustrates a section of a horizontal projection of a package in accordance with one or more embodiments;
- Fig. 3: schematically and exemplarily illustrates a section of a perspective projection of a power semiconductor chip in accordance with one or more embodiments;
- Fig. 4: schematically and exemplarily illustrates a section of a horizontal projection of a package in accordance with one or more embodiments;
- Fig. 5: schematically and exemplarily illustrates a section of a circuit diagram of a system in accordance with one or more embodiments.

### DETAILED DESCRIPTION

In the following detailed description, reference is made to the accompanying drawings which form a part hereof and in which are shown by way of illustration specific embodiments in which the invention may be practiced.

In this regard, directional terminology, such as "top", "bottom", "below", "front", "behind", "back", "leading", "trailing", "below", "above" etc., may be used with reference to the orientation of the figures being described. Because parts of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

Reference will now be made in detail to various embodiments, one or more examples of which are illustrated in the figures. Each example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations. The examples are described using specific language which should not be construed as limiting the scope of the appended claims. The drawings are not scaled and are for illustrative purposes only. For clarity, the same elements or manufacturing steps have been designated by the same references in the different drawings if not stated otherwise.

The term "horizontal" as used in this specification intends to describe an orientation substantially parallel to a horizontal surface of a semiconductor substrate or of a semiconductor structure. This can be for instance the surface of a semiconductor wafer or a chip. For example, both the (first) lateral direction X and the (second) lateral direction Y mentioned below can be horizontal directions, wherein the first lateral direction X and the second lateral direction Y may be perpendicular to each other.

The term "vertical" as used in this specification intends to describe an orientation which is substantially arranged perpendicular to the horizontal surface, i.e., parallel to the normal direction of the surface of the semiconductor wafer/chip. For example, the extension direction Z mentioned below may be an extension direction that is perpendicular to both the first lateral direction X and the second lateral direction Y.

In the context of the present specification, the terms "in ohmic contact", "in electric contact", "in ohmic connection", and "electrically connected" intend to describe that there is a low ohmic electric connection or low ohmic current path between two regions, sections, zones, portions or parts of the device described herein. Further, in the context of the present specification, the term "in contact" intends to describe that there is a direct physical connection between two elements of the respective semiconductor device; e.g., a transition between two elements being in contact with each other may not include a further intermediate element or the like.

In addition, in the context of the present specification, the term "electric insulation" is used, if not stated otherwise, in the context of its general valid understanding and thus intends to describe that two or more components are positioned separately from each other and that there is no ohmic connection connecting those components. However, components being electrically insulated from each other may nevertheless be coupled to each other, for example mechanically coupled and/or capacitively coupled and/or inductively coupled. To give an example, two electrodes of a capacitor may be electrically insulated from each other and, at the same time, mechanically and capacitively coupled to each other, e.g., by means of an insulation, e.g., a dielectric.

Specific embodiments described in this specification pertain to, without being limited thereto, a power semiconductor chip, e.g., a power semiconductor chip that may be used within a power converter or a power supply. Thus, in an embodiment, such chip can be configured to carry a load current that is to be fed to a load and/or, respectively, that is provided by a power source. For example, the chip may comprise one or more active power semiconductor cells, such as a monolithically integrated diode cell, and/or a monolithically integrated transistor cell, and/or a monolithically integrated IGBT cell, and/or a monolithically integrated RC-IGBT cell, and/or a monolithically integrated MOS Gated Diode (MGD) cell, and/or a monolithically integrated MOSFET cell and/or derivatives thereof. A plurality of such diode cells and/or such transistor cells may be integrated in the chip.

The term "power semiconductor chip" as used in this specification intends to describe a single chip with high voltage blocking and/or high current-carrying capabilities. In other words, such power semiconductor chip is intended for high current, typically in the Ampere range, e.g., up to 5 or 100 Amperes or even up to 1.000 A and above, and/or voltages typically above 15 V, more typically up to 40 V, and above, e.g., up to at least 500 V or more than 500 V, e.g. at least 600 V, or even up to 2.000 V and above.

For example, the power semiconductor chip described below may be a chip that is configured to be employed as a power component in a low-, medium- and/or high voltage application. For example, the term "power semiconductor chip" as used in this specification is not directed to logic semiconductor devices that are used for, e.g., storing data, computing data and/or other types of semiconductor based data processing.

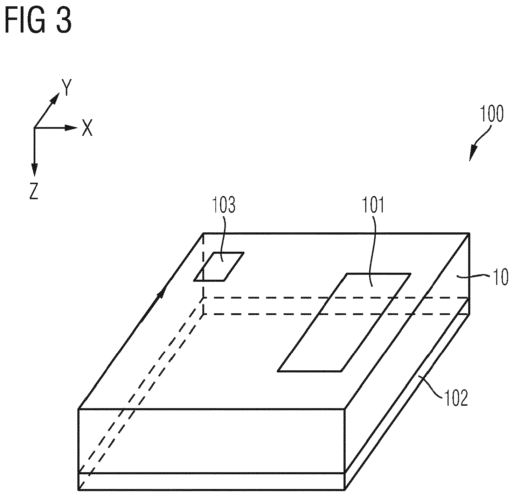

Fig. 3 schematically and exemplarily illustrates a section of a perspective projection of a power semiconductor chip 100 in accordance with one or more embodiments. The power semiconductor chip 100 has a first load terminal 101 and a second load terminal 102. The power semiconductor chip 100 is configured to block a blocking voltage applied between said load terminals 101, 102 and to conduct a chip load current between said load terminals 101, 102.

The power semiconductor chip 100 may have been processed, together with other power semiconductor chips, within a semiconductor wafer which has been diced into the individual power semiconductor chips after completion of the wafer processing. For example, during such wafer processing, the first load terminal 101 is formed for each designated chip, e.g., by depositing an electrically conductive material, e.g. a metal, on a front side of the wafer. Forming the first load terminals 101 on the front side of the wafer may include using a mask. The first load terminals 101 are typically formed after the configuration of the semiconductor body 10 is finished.

The second terminal 102 is typically formed on a backside of the wafer, e.g., without a mask but substantially homogeneously along the entire back side. For example, the second load terminal 102 may include a backside metallization.

Hence, the chip 100 can have a vertical configuration, according to which the first load terminal 101 is arranged at the chip front side and the second load terminal 102 is arranged at a chip backside. In lateral directions, e.g., in the lateral directions X and Y and linear combinations thereof, the chip may be terminated by a chip edge, e.g., a side surface extending in the vertical direction Z.

The semiconductor body 10 is coupled between the first load terminal 101 and the second load terminal 102. E.g., if a voltage applied between the first load terminal 101 and the second load terminal 102 is positive (e.g., the electrical potential of the second load terminal 102 being greater than the electrical potential of the first load terminal 101), the semiconductor body 10 conducts the load current between the load terminals 101 and 102. If the voltage is negative, the semiconductor body 10 may be configured to block such voltage and inhibit a flow of the load current between the load terminals 101, 102.

For example, the power semiconductor chip 100 may be a diode, wherein, for example, the first load terminal 101 can be a cathode terminal and the second load terminal 102 can be an anode terminal.

In another embodiment, the power semiconductor chip 100 can be a controllable power semiconductor chip, such as a transistor or a gated diode or a thyristor or a derivative of one of the aforementioned variants. For example, the power semiconductor chip 100 may comprise a control terminal 103, which is typically arranged also at the front side of the power semiconductor chip 100. In an embodiment, the first load terminal 101 may hence be a source/emitter terminal, and the second load terminal 102 may be a drain/collector terminal.

The possible basic configurations of the power semiconductor chip 100 (transistor (e.g., MOSFET, IGBT etc.), diode and thyristor) are known to the skilled person and, hence, it is refrained from explaining these in more detail. Embodiments described herein are not limited to a specific type of a power semiconductor chip. For example, the chips may also be designed as monolithic bidirectionally blocking and conducting power semiconductor chips. E.g., each of the chips can be a Si-, SiC-MOSFET or a GaN-HEMT (high-electron-mobility transistor).

Further, it shall be noted that the first load terminal 101 could also be arranged at the back side of the power semiconductor chip 100, and that the second load terminal 102 could also be arranged at the front side of the power semiconductor chip 100.

Before being able to be employed within an application, the power semiconductor chip 100 is usually included within a package that may allow mechanically mounting and electrically connecting the chip within the application, e.g., also for heat distribution purposes. Such package may environmentally seal the included power semiconductor chip 100.

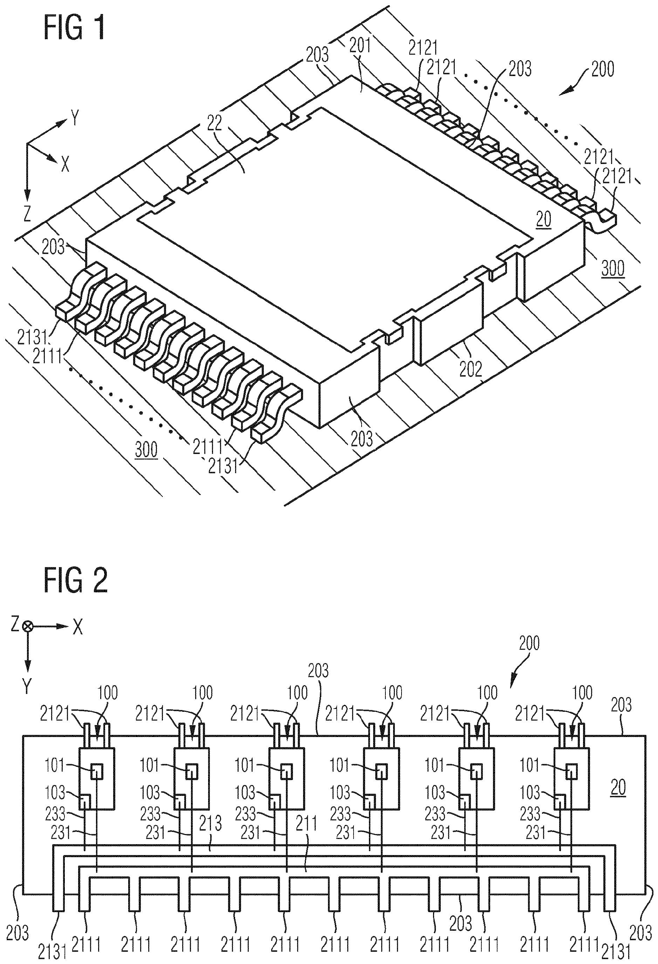

Fig. 1 schematically and exemplarily illustrates a section of a perspective projection of a package 200 in accordance with one or more embodiments.

The package 200 comprises a package body 20 with a package top side 201, a package footprint side 202 and package sidewalls 203, the package sidewalls 203 extending from the package footprint side 202 to the package top side 201.

The package body 20 can be made of or, respectively, comprise a molding mass. For example, the package body 20 exhibits a flat configuration, according to which: each of the package top side 201 the package footprint side 202 extend substantially horizontally along the first and second lateral directions X and Y; the package sidewalls 203 extend substantially vertically along the vertical direction Z; and a maximum horizontal extension of the package footprint side 202 amounts to at least twice of a maximum vertical extension of the package sidewalls 203.

A lead frame structure of the package 100 is configured to electrically and mechanically couple the package 200 to a carrier 300 with the package footprint side 202 facing to the carrier 300.

The carrier 300 may be a printed circuit-board (PCB) or may be a component of a PCB. In another embodiment, the carrier 300 may be a Direct Copper Bond (DCB) substrate, e.g. a ceramic circuit board, or may be a component of a DCB substrate. In yet another embodiment, the carrier 300 may also be based on an Insulated Metallic Substrate (IMS). The carrier 300 may be made of an electrically insulating material, e.g., made of a polymer, a PCB laminate, a ceramic, a flame retardant (FR) material (e.g., FR4), a composite epoxy material (CEM), such as CEM1 or CEM3, a Bismaleimide-Triazine resin (BT) material, imide, polyimide, ABF, or made of a combination of the aforementioned exemplary materials.

The package 200 encloses a plurality of power semiconductor chips 100 electrically connected in parallel to each other, each power semiconductor chip 100 having a first load terminal 101 and a second load terminal 102 and being configured to block a blocking voltage applied between said load terminals 101, 102 and to conduct a chip load current between said load terminals 101, 102.

The explanation of the power semiconductor chip 100 presented above with respect to Fig. 3 may equally apply to each power semiconductor chip 100 included in the package 200.

In an embodiment, the chips 100 included in the package 200 are equally configured. E.g., each chip 100 exhibits the same MOSFET configuration.

For example, the chips 100 are sandwiched in between the package top side 201 and the package footprint side 202. The package body 20 may entirely surround the chips 100 and seal the chips 200 against the environment.

The lead frame structure of the package 200 may serve as an electrically conductive interface between the first load terminals 101 of the chips 100 (and, if present, the one or more further terminals of the chips (control and/or sense terminals) and other components (not illustrated) that are fixed at the carrier 300. For example, the carrier 300 may comprise or be provided with other components (not illustrated; for example, one or more other packages including one or more other chips, and/or a controller, a sensor, a passive component, a load or the like) to which the terminals of the chips 100 are to be coupled via the lead frame structure. A connection between the lead frame structure and the terminals of the chips 100, e.g., the first load terminals 101, may be realized by package internal connection means, and for connecting the chips with other components external of the package 200, the lead frame structure may comprise one or more outside terminals, as will now be explained in more detail further below.

As used herein, electrically connected in parallel to each other shall mean that all first load terminals 101 of the chips 100 enclosed in the package 200 exhibit the substantially the same first electrical potential, and that all second load terminals 102 of the enclosed chips 100 exhibit the substantially the same second electrical potential. For example, the total load current of the package is collectively conducted by the plurality of chips 100.

For example, each chip 100 exhibits the same on-state resistance (Rₒₙ), and the total on-state resistance of the package 200 amounts hence to approximately Rₒₙ divided by the total number of chips 100.

In the following, it is additionally referred to Fig. 2, which schematically and exemplarily illustrates a section of a horizontal projection of the package 200 in accordance with one or more embodiments.

The lead frame structure comprises a first load terminal bar 211 and at least one first outside terminal 2111, the at least one first outside terminal 2111 extending out of the package body 20 for interfacing with the carrier 300 and being electrically connected with each of the first load terminals 101 of the plurality of power semiconductor chips 100 by means of the first load terminal bar 211. As illustrated in Figs. 1 and 2, there can of course be more than one first outside terminal 2111; e.g., at least one first outside terminal 2111 is provided for each power semiconductor chip 100. Or, at least two first outside terminals 2111 are provided for each power semiconductor chip 100.

For the electrical connection of the second load terminals 102, the package 200 may comprise at least one second outside terminal 2121 extending out of the package body 20 for interfacing with the carrier 300 and being electrically connected with each of the second load terminals 102 of the plurality of power semiconductor chips 100. As illustrated in Figs. 1 and 2, there can of course be more than one second outside terminal 2121; e.g., at least one second outside terminal 2121 is provided for each power semiconductor chip 100. Or, at least two first outside terminals 2121 are provided for each power semiconductor chip 100.

If present, for electrical connection of the control terminals 103, the package 200 may comprise at least one third outside terminal 2131 extending out of the package body 20 for interfacing with the carrier 300 and being electrically connected with each of the control terminals 103 of the plurality of power semiconductor chips 100. As illustrated in Figs. 1 and 2, there can of course be more than one third outside terminal 2131; e.g., two third outside terminals 2131. However, since controlling the power semiconductor chips 100 by means of supplying a control signal to the control terminals 103 does typically not require a high current, one or two third outside terminals 2131 may be sufficient. For example, one or two third outside terminals 2131 are connected, within the package body 20, to each control terminal 103 of the enclosed power semiconductor chips 100.

According to the aforesaid, the first outside terminals 2111 are electrically insulated from the second outside terminals 2121. If present, the one or more third outside terminals 2131 are electrically insulated from each of the first outside terminals 2111 and from each of the second outside terminals 2121. For example, to this end, as illustrated in Figs. 1 and 2, it can be appropriate to design the package 200 such that the second outside terminals 2121 extend out of a first one of the package sidewalls 203, and that the first outside terminals 2111 extend out of a second one of the package sidewalls 203 opposite of the first package sidewall. Furthermore, since the control signal may for example be provided by means of generating a voltage difference between the first load terminals 101 and the control terminal 103, the third outside terminals 2131 may also extend out of the second package sidewall.

One or more or each of the outside terminals 2111, 2121 and 2131 may be configured to be electrically and mechanically coupled to the carrier 300, e.g., by soldering. Within the present specification, the term "outside" may express that the outside terminals 2111, 2121 and 2131 may be configured to be electrically contacted by means of components external of the package body 20.

Further, the outside terminals 2111, 2121 and 2131 may be designed as pins, as best illustrated in Fig. 1. In another embodiment, e.g., for forming a so-called leadless package, the outside terminals 2111, 2121 and 2131 of the package 200 are flat planar outside terminals. For example, within the present specification, the term "flat planar" may express that the outside terminals 2111, 2121 and 2131 each exhibit a respective substantially plane bottom surface that has a size with horizontal dimensions (e.g. along each of the first lateral direction X and the second lateral direction Y) at least as great as a vertical dimension of the respective outside terminal (e.g. along the vertical direction Z), said plane bottom surface laterally overlapping with the package footprint side 202. Thus, the package 200 may be a leadless package, e.g., an SMD leadless package. In another embodiment, the outside terminals 2111, 2121 and 2131 are configured as contact pins (as illustrated) or as contact balls.

In the package body 20, the plurality of power semiconductor chips 100 are arranged horizontally adjacent to each other along the first lateral direction X. E.g., in terms of the second lateral direction Y and/or the vertical direction Z, each chip 100 has the same position. For example, each of the power semiconductor chips 100 is arranged at the same vertical level within the package body 20. The chips 100 may be arranged equidistantly, e.g., with distance within the range of 0.5 mm to 5.0 mm, along the first lateral direction X being present between each pair of adjacent chips 100.

The first load terminal bar 211 of the lead frame structure also extends along the first lateral direction X so as to subsequently establish electrical contact with the first load terminals 101 of the power semiconductor chips 100.

E.g., the package 200 further comprises a plurality of first connecting members 231, e.g., wire bonds, that connect the first load terminals 101 of the power semiconductor chips 100 with the first load terminal bar 211. The first load terminal bar 211 may be spatially displaced from the plurality of chips 100 along the second lateral direction Y, e.g., by a distance within the range of 0.5 mm to 5.0 mm.

In an embodiment, the first outside terminals 2111 extend away from the first load terminal bar 211 (within the package body 20) along the second lateral direction Y so as to penetrate the first package sidewall 203 and reach the exterior of the package 200 where they may interface with the carrier 300, as illustrated in Figs. 1 and 2.

Hence, realization of the parallel connection of the plurality of chips 100 may at least partially be accomplished by means of the first load terminal bar 211 and the first connecting members 231.

For example, the total extension of the first load terminal bar 211 in the first lateral direction may be at least as great as the total extension of the array formed by the plurality of chips 100 in the first lateral direction X; e.g., the first load terminal bar 211 overlaps with each of the chips 100 along the first lateral direction X.

In an embodiment, the package 200 comprises a horizontally extending conduction layer 22 at the package top side 201 (as illustrated in Fig. 1) or at the package footprint side 202, wherein the conduction layer 22 is electrically connected with either each of the second load terminals 102 or with each of the first load terminals 101 of the plurality of power semiconductor chips 100. For example, the package 200 may hence exhibit a TSC configuration. The conduction layer 22 can be monolithic and may laterally overlap with each of the power semiconductor chips 100, e.g., in both the first and the second lateral direction X and Y. For example, as best illustrated in Fig. 1, the top layer 22 is arranged substantially coplanar with the package top side 201; e.g., the top layer 22 does substantially not protrude from the package top side 201. The top layer 22 can have a horizontal surface area amounting to at least 50%, to at least 60% or to even more than 80% (but to less than 100%) of the total surface area of the package top side 201. This surface area may be exposed to the environment of the package body 20, i.e., the surface area of the top layer 22 is not enclosed within the package body 20, but forms a part of an exterior surface.

In another embodiment, the conduction layer 22 is arranged at the package footprint side 202 and, hence, the package 200 may then exhibit a bottom side cooling configuration.

As indicated above, each of the enclosed chips 100 can be controllable and comprise a respective control terminal 103. In such case, the package 200 may comprise a control terminal bar 213 extending along the first lateral direction X so as to subsequently establish electrical contact with the control terminals 103, as illustrated in Fig. 2.

In an embodiment, the package 200 comprises no more than two third outside terminals 2131 for interfacing with the carrier 300, wherein the no more than two third outside terminals 2131 are electrically connected to the control terminal bar 213. For example, the package 200 encloses four, six, eight or even more than ten chips 100, yet no more than two third outside terminals 2131 are provided. By means of the control terminal bar 213, the control signal (e.g., induced by a voltage applied between the first outside terminals 2111 and the one or two third outside terminal(s) 2131) can be provided to the control terminal 103 of each chip 100.

Similar to the first connecting members 231, the package 200 may comprise a plurality of third connecting members 233, e.g., wire bonds, that connect the control terminals 103 of the power semiconductor chips 100 with the control terminal bar 213. The control terminal bar 213 may be spatially displaced from the plurality of chips 100 along the second lateral direction Y, e.g., by a distance within the range of 0.5 mm to 5.0 mm.

In an embodiment, the third outside terminals 2131 extend away from the control terminal bar 213 (within the package body 20) along the second lateral direction Y so as to penetrate the first package sidewall 203 and reach the exterior of the package 200 where they may interface with the carrier 300, as illustrated in Figs. 1 and 2.

As illustrated in Fig. 2, the first load terminal bar 211 and the control terminal bar 213 can be arranged adjacent to each other along a second lateral direction Y. For example, due to the higher number of first outside terminals 2111 (as compared to the number of third outside terminals 2131), it may be appropriate to position the control terminal bar 213 between, with respect to the second lateral direction Y, the array of chips 100 and the first load terminal bar 211. For example, the first connecting members 231 extend either below or above (with respect to the vertical direction Z) the control terminal bar 213 so as to connect to the first load terminal bar 211.

In an embodiment, the first load terminal bar 211 is positioned between, with respect to the first lateral direction X, the two third outside terminals 2131, as illustrated in Fig. 2.

Regarding the electrical connection for the second load terminals 102 of the chips 100, the second outside terminals 2121 may directly interface with the second load terminals 102, as illustrated in Fig. 2. In another embodiment, a second load terminal bar (not illustrated) may be arranged between the second package sidewall 203 and the array of chips 100, similarly to the first load terminal bar 211. In yet another embodiment, the second load terminals 102 are electrically connected to the conduction layer 22. For example, the second load terminals 102 are exclusively electrically connected to the conduction layer 22, and no second outside terminals 2121 are provided.

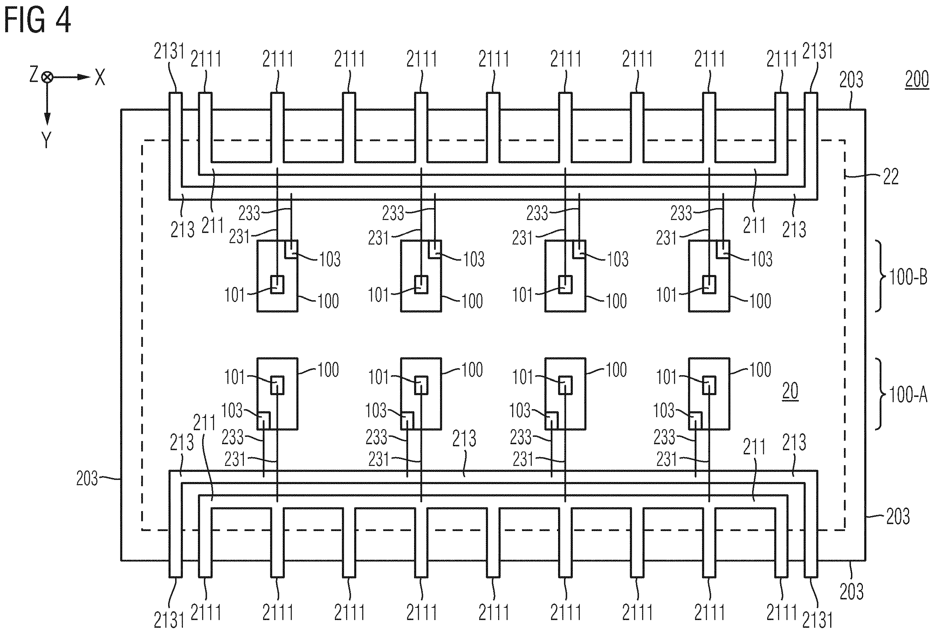

Fig. 4 schematically and exemplarily illustrates a section of a horizontal projection of the package 200 in accordance with one or more further embodiments. For example, the plurality of power semiconductor chips 100 comprises a first subset of N > 2 power semiconductor chips 100 and a second subset of N power semiconductor chips 100. E.g., N equals to two, three, four, five, six, seven, eight, nine, or ten. N may even be greater than ten, e.g., equal to or greater than 12, 14 and so on. The total number of chips 100 included in the package 200 may hence be equal to 2*N.

In an embodiment, the N power semiconductor chips 100 of the first subset are arranged along a first path 100-A that extends in the first lateral direction X, e.g., in a manner as already explained with respect to Fig. 2. Further, the N power semiconductor chips 100 of the second subset are arranged along a second path 100-B parallel to the first path 100-A and horizontally displaced therefrom, e.g., along the second lateral direction Y. Also the N chips 100 of the second subset may be arranged in a manner as already explained with respect to Fig. 2. Each of the 2*N chips of the first and the second subset may have the same position with regards to the vertical direction Z.

The lead frame structure of the package 200 may comprise a first load terminal bar 211 for both array of chips 100-A and 100-B, as illustrated in Fig. 4. The first load terminal bar 211 for the first array of N chips 100-A extends along the first lateral direction X so as to subsequently establish electrical contact with the first load terminals 101 of the N power semiconductor chips 100 of the first subset, e.g., in a manner as already explained with respect to Fig. 2. This may include providing the first connecting members 231.

The further first load terminal bar 211 for the N chips 100 of the second subset in the second array 100-B also extends along the first lateral direction X so as to subsequently establish electrical contact with the first load terminals 101 of the power semiconductor chips 100 of the second subset, e.g., in a manner as already explained with respect to Fig. 2. This may include providing the first connecting members 231 for the chips 100 of the second subset.

For example, the first load terminal bar 211 for the N chips 100 of the first array 100-A is arranged between the first array 100-A and first one of the package sidewalls 203. As illustrated, the further first load terminal bar 211 for the N chips 100 of the second array 100-B may be arranged between the second array 100-B and the second one of the package sidewalls 203 opposite of the first package sidewall 203.

For example, as already explained above, the conduction layer 22 is used to provide, e.g., at the package top side 201, an electrical connection of the second load terminals 102 of each of the 2*N power semiconductor chips 100. Hence, an external contact can be coupled to the conduction layer 22 and, within the package body 20, the conduction layer 22 is electrically connected to the second load terminals 102 of each of the 2*N power semiconductor chips 100. In another (non illustrated) embodiment, a second load terminal bar (not illustrated) can be provided, e.g., between, with respect to the second lateral direction Y, the first array 100-A and the second array 100-B, wherein the second load terminal bar can be electrically connected to each of the second load terminals 102 of each of the 2*N power semiconductor chips 100. Further, a plurality of second outside terminals (cf. reference numeral 2121 in Fig. 2, not illustrated) may be provided that are electrically connected to the second load terminal bar that extend out of the package body 20, e.g., at one or both of the package sidewalls 203 that extend along the second lateral direction Y (left right package sidewall in Fig. 4).

In accordance with the embodiment of Fig. 4, the parallel connection of all 2*N power semiconductor chips 100 may be established by electrically connecting each of the first outside terminals 2111 with each other, wherein this electrical connection may also occur exterior of the package body 20. Further, the parallel connection of all 2*N power semiconductor chips 100 may be established by electrically connecting each of the third outside terminals 2131 with each other, wherein this electrical connection may also occur exterior of the package body 20.

In accordance with the embodiment of Fig. 4, the package may further include the horizontally extending conduction layer 22 at the package top side 201 (as shown) or at the package footprint side 202. If arranged at the package top side, the horizontally extending conduction layer 22 can be a top side cooling layer. Hence, the package 200 of Fig. 4 may exhibit a TSC configuration. The horizontally extending conduction layer 22 may laterally overlap, along both the first and second lateral direction X and Y, with some or all of the power semiconductor chips 100 included in the package 200.

Regarding all embodiments described herein, the power semiconductor chips 100 in the package 200 can be configured to be collectively set into a respective conducting state, e.g., by means of providing a corresponding control signal at the third outside terminals 2131, wherein the first outside terminals 2111 and the second outside terminals 2121 are configured to conduct at least the sum of the chip load currents during the conducting state. For example, during the conducting state, the total load current is equally distributed among the power semiconductor chips 100 included in the package 200; e.g., if 2*N power semiconductor chips 100 included in the package 200, during the conducting state, each chip 100 conducts a share of the total load current Iₜₒₜₐₗ amounting to approximately Iₜₒₜₐₗ / (2*N), herein referred to as chip load current.

The parallel connection of the chips 100 included in the package 200 allows achieving a comparatively low total on-state resistance of the package 200. For example, the total on-state resistance of the package 200 can be equal to or smaller 5 mOhm, or smaller than 2 mOhm, or smaller than 1 mOhm.

Further, regarding all embodiments described herein, the package 200 may not only include the first outside terminals 2111 and the second outside terminal 2121, but, optionally, one or more third outside terminals 2131. The total number of the third outside terminals 2131 can be limited to four, three, or two. In an embodiment, the package 200 includes only one third outside terminal 2131 that is electrically connected to the control terminals 103 of each power semiconductor chip 100 included in the package 200. In addition, the package 200 may include a further outside terminal (not illustrated), e.g., a sense outside terminal that is electrically connected to one or more sense terminals of one or more of the enclosed chips 100, e.g., so as to be able to measure an operating parameter, such as a temperature, a voltage and/or the actual load current.

As described above, the lead frame structure of the package 200 comprises at least the first load terminal bar(s) 211 and the first outside terminals 2111. The lead frame structure is configured to mechanically and electrically couple the package body 20 to the carrier 300 (e.g., a printed circuit board (PCB)).

In an embodiment, the lead frame structure is a metallic frame structure; hence, the lead frame structure may constitute a metal carrier arranged partially in the interior of the package body 20 and partially external of the package body 20.

A method of processing a package is provided. The method includes:
- Providing a package body with a package top side, a package footprint side and package sidewalls, the package sidewalls extending from the package footprint side to the package top side;
- Arranging a plurality of power semiconductor chips in the package body and electrically connecting the chips in parallel to each other, each power semiconductor chip having a first load terminal and a second load terminal and being configured to block a blocking voltage applied between said load terminals and to conduct a chip load current between said load terminals;
- Providing a lead frame structure configured to electrically and mechanically couple the package to a carrier with the package footprint side facing to the carrier, the lead frame structure comprising a first load terminal bar and at least one first outside terminal, the at least one first outside terminal extending out of the package body for interfacing with the carrier and being electrically connected with each of the first load terminals of the plurality of power semiconductor chips by means of the first load terminal bar;
- Processing the package such that the plurality of power semiconductor chips are arranged horizontally adjacent to each other along a first lateral direction in the package body, and such that the first load terminal bar extends along the first lateral direction so as to subsequently establish electrical contact with the first load terminals of the power semiconductor chips.

Exemplary embodiments of processing method correspond to the embodiments of the package 200 described above with respect to Figs. 1-4. For example, the processing method may include ensuring that each of the power semiconductor chips is arranged, within the package body, at the same vertical level. Hence, the total thickness (e.g., the distance between the package top side and the package footprint side) of the package does not depend on the total number of chips included in the package.

E.g., even though the processed package may hence include a plurality of chips electrically connected in parallel to each other, existing package processing platforms may be used. E.g., existing die/wire bond platforms may be employed for forming the embodiments of the package 200 described above with respect to Figs. 1-4.

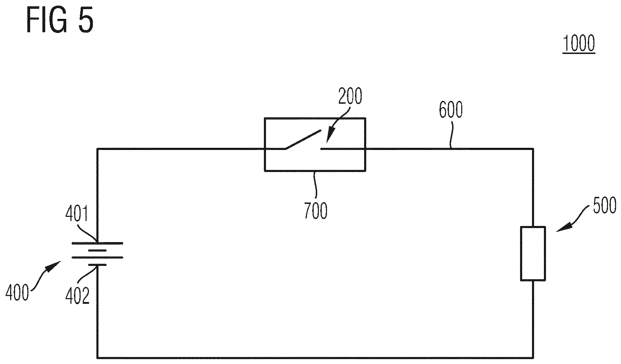

In the following, it will be referred to Fig. 5, which schematically and exemplarily illustrates a section of a circuit diagram of a system 1000 in accordance with one or more embodiments.

The system 1000 is configured to supply a load current to a load 500. The load 500 can be constituted by an electric system of a vehicle, for example. E.g., the load may comprise an electric drive of the vehicle, e.g., for driving the vehicle itself or an electric brake and/or one or more other electric components of the vehicle.

The system 1000 comprises a power supply 400 that provides a power supply signal at power supply terminals 401, 402. The power supply 400 can for example be a DC power supply, e.g., including a battery supplying a DC voltage between power supply terminals 401 and 402. The power supply 400 may alternatively or additionally comprise a (non-illustrated) power semiconductor converter circuit providing the power supply signal at the power supply terminals 401, 402, e.g., a DC voltage of at least 100 V.

The system 1000 further comprises a power supply path 600 for coupling the power supply 400 to the load 500. The power supply path 600 may include one or more of following: one or more cables, one or more wires, one or more connectors, one or more copper lines etc.

A system main switch 700 is arranged in the power supply path 600. The system main switch 700 can be configured to selectively set the power supply path 600 into a blocking state (i.e., such that the power supply path 600 is interrupted and no load current can be supplied from the power supply 400 to the load 500) and a conducting state, during which the power supply path 600 is closed and the load 500 can be supplied with the load current generated by the power supply 400. Hence, if the system main switch 700 is closed, the system main switch conducts the load current currently drawn by the load 500.

For example, the system main switch 700 can be a battery main switch. E.g., the system main switch 700 is operated at a comparatively low switching frequency, e.g., of less than 1 Hz. A main switch is typically not operated continuously with a constant switching frequency, but irregularly, e.g., only several times a day (in case of use as a battery main switch in a vehicle, for example).

The system main switch 700 comprises one or more packages 200 in accordance with one or more embodiments described above. The packages 200 are configured to conduct the load current supplied to the load 500.

Hence, a beneficial application of the embodiments of the package 200 described above may be its use within a main switch, such as a battery main switch. Such switches typically require very low static losses due long lasting on-states that may occur (e.g. for several hours or even for several days). In contrast, such applications do typically not require very low switching losses, since the switching events rather rare. Thus, embodiments of the package 200 described above may be used to replace conventional main switches, such as relays, contactors or the like.

Spatially relative terms such as "under", "below", "lower", "over", "upper" and the like, are used for ease of description to explain the positioning of one element relative to a second element. These terms are intended to encompass different orientations of the respective device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising", "exhibiting" and the like are open ended terms that indicate the presence of stated elements or features, but do not preclude additional elements or features.

With the above range of variations and applications in mind, it should be understood that the present invention is not limited by the foregoing description, nor is it limited by the accompanying drawings. Instead, the present invention is limited only by the following claims.

## Claims

1. A package (200), comprising:
- a package body (20) with a package top side (201), a package footprint side (202) and package sidewalls (203), the package sidewalls (203) extending from the package footprint side (202) to the package top side (201);
- a plurality of controllable power semiconductor chips (100) electrically connected in parallel to each other, each power semiconductor chip (100) having a control terminal (103), a first load terminal (101) and a second load terminal (102) and being configured to block a blocking voltage applied between said load terminals (101, 102) and to conduct a chip load current between said load terminals (101, 102);
- a lead frame structure for electrically and mechanically coupling the package (200) to a carrier (300) with the package footprint side (202) facing to the carrier (300), the lead frame structure comprising a first load terminal bar (211) and at least one first outside terminal (2111), the at least one first outside terminal (2111) extending out of the package body (20) for interfacing with the carrier (300) and being electrically connected with each of the first load terminals (101) of the plurality of power semiconductor chips (100) by means of the first load terminal bar (211);
wherein
- the plurality of power semiconductor chips (100) are arranged horizontally adjacent to each other along a first lateral direction (X) in the package body (20);
- the first load terminal bar (211) extends along the first lateral direction (X) so as to subsequently establish electrical contact with the first load terminals (101) of the power semiconductor chips (100);
- the package (200) comprises a control terminal bar (213) extending along the first lateral direction (X) so as to subsequently establish electrical contact with the control terminals (103), the first load terminal bar (211) and the control terminal bar (213) are arranged adjacent to each other along a second lateral direction (Y) perpendicular to the first lateral direction (X); and
- the package (200) further comprises a plurality of first connecting members (231) that connect the first load terminals (101) of the power semiconductor chips (100) with the first load terminal bar (211), **characterized in that**
- the control terminal bar (213) is arranged between the power semiconductor chips (100) and the first load terminal bar (211), and wherein the first connecting members (231) extend either below or above the control terminal bar (213) so as to connect to the first load terminal bar (211).

2. The package (200) of claim 1, further comprising a horizontally extending conduction layer (22) at the package top side (201) or at the package footprint side (202), wherein the conduction layer (22) is electrically connected with either each of the second load terminals (102) or with each of the first load terminals (101) of the plurality of power semiconductor chips (100).

3. The package (200) of claim 2, wherein the conduction layer (22) is monolithic and overlaps horizontally with each of the power semiconductor chips (100).

4. The package (200) of one of the preceding claims, wherein the package (200) comprises no more than two third outside terminals (2131) for interfacing with the carrier (300), wherein the no more than two third outside terminals (2131) are electrically connected to the control terminal bar (213).

5. The package (200) of one of the preceding claims, wherein the lead frame structure comprises at least one first outside terminal (2111) per power semiconductor chip (100).

6. The package (200) of one of the preceding claims, wherein each of the power semiconductor chips (100) is arranged at the same vertical level within the package body (20).

7. The package (200) of one of the preceding claims, wherein the lead frame structure comprises a plurality of second outside terminals (2121) extending out of the package body (20) for interfacing with the carrier (300), wherein the second outside terminals (2121) are electrically connected with the second load terminals (102) of the power semiconductor chips (100).

8. The package (200) of claim 7, wherein each of the first outside terminals (2111) extends out of a first one of the package sidewalls (203) of the package body (20), and wherein each of the second outside terminals (2121) extends out of a second one of the package sidewalls (203) of the package body (20), the first package sidewall and the second package sidewall being arranged opposite to each other.

9. The package (200) of one of the preceding claims, wherein the plurality of power semiconductor chips (100) comprises a first subset of N > 2 power semiconductor chips (100) and a second subset of N power semiconductor chips (100), wherein the power semiconductor chips (100) of the first subset are arranged along a first path (100-A) that extends in the first lateral direction (X), and wherein the power semiconductor chips (100) of the second subset are arranged along a second path (100-B) parallel to the first path (100-A) and horizontally displaced therefrom.

10. The package (200) of claim 9, wherein the lead frame structure comprises a further first load terminal bar (211), and wherein:
- the first load terminal bar (211) extends along the first lateral direction (X) so as to subsequently establish electrical contact with the first load terminals (101) of the power semiconductor chips (100) of the first subset; and
- the further first load terminal bar (211) extends along the first lateral direction (X) so as to subsequently establish electrical contact with the first load terminals (101) of the power semiconductor chips (100) of the second subset.

11. A system (1000) for supplying a load current to a load (500), the system (1000) comprising:
- a power supply (400);
- a power supply path (600) for coupling the power supply (400) to the load (500);
- a system main switch (700) in the power supply path (600), wherein the system main switch (700) comprises one or more packages (200) of one of the preceding claims, wherein the one or more packages (200) are configured to conduct the load current.

## Patentansprüche

1. Gehäuse (200), umfassend:
- einen Gehäusekörper (20) mit einer Gehäuseoberseite (201), einer Gehäuseunterseite (202) und Gehäuseseitenwänden (203), wobei sich die Gehäuseseitenwände (203) von der Gehäuseunterseite (202) zur Gehäuseoberseite (201) erstrecken;
- eine Vielzahl von steuerbaren Leistungshalbleiterchips (100), die elektrisch parallel zueinander geschaltet sind, wobei jeder Leistungshalbleiterchip (100) einen Steueranschluss (103), einen ersten Lastanschluss (101) und einen zweiten Lastanschluss (102) aufweist und dazu ausgelegt ist, eine zwischen den Lastanschlüssen (101, 102) angelegte Sperrspannung sperrt und einen Chiplaststrom zwischen den Lastanschlüssen (101, 102) leitet;
- eine Leiterrahmenstruktur zum elektrischen und mechanischen Koppeln des Gehäuses (200) mit einem Träger (300), wobei die Gehäuseunterseite (202) dem Träger (300) zugewandt ist, wobei die Leiterrahmenstruktur eine erste Lastanschlussschiene (211) und mindestens einen ersten Außenanschluss (2111) umfasst, wobei sich der mindestens eine erste Außenanschluss (2111) aus dem Gehäusekörper (20) heraus erstreckt, um eine Schnittstelle mit dem Träger (300) zu bilden, und mit jedem der ersten Lastanschlüsse (101) der Vielzahl von Leistungshalbleiterchips (100) mittels der ersten Lastanschlussschiene (211) elektrisch verbunden ist;
wobei
- die Vielzahl von Leistungshalbleiterchips (100) horizontal angrenzend aneinander entlang einer ersten Querrichtung (X) im Gehäusekörper (20) angeordnet sind;
- sich die erste Lastanschlussschiene (211) entlang der ersten Querrichtung (X) erstreckt, um anschließend einen elektrischen Kontakt mit den ersten Lastanschlüssen (101) der Leistungshalbleiterchips (100) herzustellen;
- das Gehäuse (200) eine Steueranschlussschiene (213) umfasst, die sich entlang der ersten Querrichtung (X) erstreckt, um anschließend einen elektrischen Kontakt mit den Steueranschlüssen (103) herzustellen, wobei die erste Lastanschlussschiene (211) und die Steueranschlussschiene (213) aneinander angrenzend entlang einer zweiten Querrichtung (Y) rechtwinklig zur ersten Querrichtung (X) angeordnet sind; und
- das Gehäuse (200) ferner eine Vielzahl von ersten Verbindungselementen (231) umfasst, die die ersten Lastanschlüsse (101) der Leistungshalbleiterchips (100) mit der ersten Lastanschlussschiene (211) verbinden,
**dadurch gekennzeichnet, dass**
- die Steueranschlussschiene (213) zwischen den Leistungshalbleiterchips (100) und der ersten Lastanschlussschiene (211) angeordnet ist, und wobei sich die ersten Verbindungselemente (231) entweder unterhalb oder oberhalb der Steueranschlussschiene (213) erstrecken, um mit der ersten Lastanschlussschiene (211) verbunden zu werden.

2. Gehäuse (200) gemäß Anspruch 1, ferner umfassend eine sich horizontal erstreckende Leitungsschicht (22) an der Gehäuseoberseite (201) oder an der Gehäuseunterseite (202), wobei die Leitungsschicht (22) entweder mit jedem der zweiten Lastanschlüsse (102) oder mit jedem der ersten Lastanschlüsse (101) der Vielzahl von Leistungshalbleiterchips (100) elektrisch verbunden ist.

3. Gehäuse (200) gemäß Anspruch 2, wobei die Leitungsschicht (22) monolithisch ist und sich horizontal mit jedem der Leistungshalbleiterchips (100) überlappt.

4. Gehäuse (200) gemäß einem der vorhergehenden Ansprüche, wobei das Gehäuse (200) nicht mehr als zwei dritte Außenanschlüsse (2131) umfasst, um eine Schnittstelle mit dem Träger (300) zu bilden, wobei die nicht mehr als zwei dritten Außenanschlüsse (2131) elektrisch mit der Steueranschlussschiene (213) verbunden sind.

5. Gehäuse (200) gemäß einem der vorhergehenden Ansprüche, wobei die Leiterrahmenstruktur mindestens einen ersten Außenanschluss (2111) pro Leistungshalbleiterchip (100) umfasst.

6. Gehäuse (200) gemäß einem der vorhergehenden Ansprüche, wobei jeder der Leistungshalbleiterchips (100) auf der gleichen vertikalen Ebene innerhalb des Gehäusekörpers (20) angeordnet ist.

7. Gehäuse (200) gemäß einem der vorhergehenden Ansprüche, wobei die Leiterrahmenstruktur eine Vielzahl von zweiten Außenanschlüssen (2121) umfasst, die sich aus dem Gehäusekörper (20) heraus erstrecken, um eine Schnittstelle mit dem Träger (300) zu bilden, wobei die zweiten Außenanschlüsse (2121) elektrisch mit den zweiten Lastanschlüssen (102) der Leistungshalbleiterchips (100) verbunden sind.

8. Gehäuse (200) gemäß Anspruch 7, wobei sich jeder der ersten Außenanschlüsse (2111) aus einer ersten der Gehäuseseitenwände (203) des Gehäusekörpers (20) heraus erstreckt und wobei sich jeder der zweiten Außenanschlüsse (2121) aus einer zweiten der Gehäuseseitenwände (203) des Gehäusekörpers (20) heraus erstreckt, wobei die erste Gehäuseseitenwand und die zweite Gehäuseseitenwand einander gegenüberliegend angeordnet sind.

9. Gehäuse (200) gemäß einem der vorhergehenden Ansprüche, wobei die Vielzahl von Leistungshalbleiterchips (100) eine erste Teilmenge von N > 2 Leistungshalbleiterchips (100) und eine zweite Teilmenge von N Leistungshalbleiterchips (100) umfasst, wobei die Leistungshalbleiterchips (100) der ersten Teilmenge entlang eines ersten Weges (100-A) angeordnet sind, der sich in der ersten Querrichtung (X) erstreckt, und wobei die Leistungshalbleiterchips (100) der zweiten Teilmenge entlang eines zweiten Weges (100-B) angeordnet sind, der parallel zum ersten Weg (100-A) verläuft und von diesem horizontal versetzt ist.

10. Gehäuse (200) gemäß Anspruch 9, wobei die Leiterrahmenstruktur eine weitere erste Lastanschlussschiene (211) umfasst, und wobei:
- sich die erste Lastanschlussschiene (211) entlang der ersten Querrichtung (X) erstreckt, um anschließend einen elektrischen Kontakt mit den ersten Lastanschlüssen (101) der Leistungshalbleiterchips (100) der ersten Teilmenge herzustellen; und
- sich die weitere erste Lastanschlussschiene (211) entlang der ersten Querrichtung (X) erstreckt, um anschließend einen elektrischen Kontakt mit den ersten Lastanschlüssen (101) der Leistungshalbleiterchips (100) der zweiten Teilmenge herzustellen;

11. System (1000) zum Liefern eines Laststroms an eine Last (500), wobei das System (1000) umfasst:
- eine Stromversorgung (400);
- einen Stromversorgungsweg (600) zum Koppeln der Stromversorgung (400) mit der Last (500);
- einen Systemhauptschalter (700) im Stromversorgungsweg (600), wobei der Systemhauptschalter (700) ein oder mehrere Gehäuse (200) gemäß einem der vorhergehenden Ansprüche umfasst, wobei das eine oder die mehreren Gehäuse (200) dazu ausgelegt sind, den Laststrom zu leiten.

## Revendications

1. Boîtier (200), comprenant :
un corps de boîtier (20) avec une face supérieure de boîtier (201), une face d'empreinte de boîtier (202) et des parois latérales de boîtier (203), les parois latérales de boîtier (203) s'étendant de la face d'empreinte de boîtier (202) à la face supérieure de boîtier (201) ;
- une pluralité de puces à semi-conducteurs de puissance contrôlables (100) connectées électriquement en parallèle les unes aux autres, chaque puce à semi-conducteurs de puissance (100) ayant une borne de commande (103), une première borne de charge (101) et une deuxième borne de charge (102) et étant configurée pour bloquer une tension de blocage appliquée entre lesdites bornes de charge (101, 102) et pour conduire un courant de charge de puce entre lesdites bornes de charge (101, 102) ;
- une structure de grille de connexion pour coupler électriquement et mécaniquement le boîtier (200) à un support (300), la face d'empreinte du boîtier (202) étant tournée vers le support (300), la structure de grille de connexion comprenant une première barre de bornes de charge (211) et au moins une première borne extérieure (2111), l'au moins une première borne extérieure (2111) s'étendant hors du corps du boîtier (20) pour assurer l'interface avec le support (300) et étant connectée électriquement à chacune des premières bornes de charge (101) de la pluralité de puces à semi-conducteurs de puissance (100) au moyen de la première barre de bornes de charge (211) ;
où
- la pluralité de puces à semi-conducteurs de puissance (100) sont disposées horizontalement de manière adjacente les unes à côté des autres le long d'une première direction latérale (X) dans le corps de boîtier (20) ;
- la première barre de bornes de charge (211) s'étend le long de la première direction latérale (X) de manière à établir ensuite un contact électrique avec les premières bornes de charge (101) des puces à semi-conducteurs de puissance (100) ;
- le boîtier (200) comprend une barre de bornes de commande (213) s'étendant le long de la première direction latérale (X) de manière à établir ensuite un contact électrique avec les bornes de commande (103), la première barre de bornes de charge (211) et la barre de bornes de commande (213) sont disposées de manière adjacente les unes à côté des autres le long d'une deuxième direction latérale (Y) perpendiculaire à la première direction latérale (X) ; et
- le boîtier (200) comprend en outre une pluralité de premiers éléments de connexion (231) qui relient les premières bornes de charge (101) des puces à semi-conducteurs de puissance (100) à la première barre de bornes de charge (211), **caractérisé en ce que** :
- la barre de bornes de commande (213) est disposée entre les puces à semi-conducteurs de puissance (100) et la première barre de bornes de charge (211), et où les premiers éléments de connexion (231) s'étendent soit en dessous soit au-dessus de la barre de bornes de commande (213) de manière à se connecter à la première barre de bornes de charge (211).

2. Boîtier (200) selon la revendication 1, comprenant en outre une couche de conduction (22) s'étendant horizontalement sur la face supérieure du boîtier (201) ou sur la face de l'empreinte du boîtier (202), où la couche de conduction (22) est connectée électriquement soit à chacune des deuxièmes bornes de charge (102), soit à chacune des premières bornes de charge (101) de la pluralité de puces à semi-conducteurs de puissance (100) .

3. Boîtier (200) selon la revendication 2, dans lequel la couche de conduction (22) est monolithique et chevauche horizontalement chacune des puces à semi-conducteurs de puissance (100).

4. Boîtier (200) selon l'une des revendications précédentes, dans lequel le boîtier (200) ne comprend pas plus de deux tiers de bornes extérieures (2131) pour assurer l'interface avec le support (300), où les pas plus de deux tiers de bornes extérieures (2131) sont connectées électriquement à la barre de bornes de commande (213) .

5. Boîtier (200) selon l'une des revendications précédentes, dans lequel la structure de grille de connexion comprend au moins une première borne extérieure (2111) par puce à semi-conducteurs de puissance (100).

6. Boîtier (200) selon l'une des revendications précédentes, dans lequel chacune des puces à semi-conducteurs de puissance (100) est disposée au même niveau vertical à l'intérieur du corps du boîtier (20).

7. Boîtier (200) selon l'une des revendications précédentes, dans lequel la structure de grille de connexion comprend une pluralité de deuxièmes bornes extérieures (2121) s'étendant hors du corps du boîtier (20) pour assurer l'interface avec le support (300), où les deuxièmes bornes extérieures (2121) sont électriquement connectées aux deuxièmes bornes de charge (102) des puces à semi-conducteurs de puissance (100) .

8. Boîtier (200) selon la revendication 7, dans lequel chacune des premières bornes extérieures (2111) s'étend hors d'une première des parois latérales (203) du corps de boîtier (20), et où chacune des deuxièmes bornes extérieures (2121) s'étend hors d'une deuxième des parois latérales (203) du corps de boîtier (20), la première paroi latérale du boîtier et la deuxième paroi latérale du boîtier étant disposées à l'opposé l'une de l'autre.

9. Boîtier (200) selon l'une des revendications précédentes, dans lequel la pluralité de puces à semi-conducteurs de puissance (100) comprend un premier sous-ensemble de N > 2 puces à semi-conducteurs de puissance (100) et un deuxième sous-ensemble de N puces à semi-conducteurs de puissance (100), où les puces à semi-conducteurs de puissance (100) du premier sous-ensemble sont disposées le long d'un premier chemin (100-A) qui s'étend dans la première direction latérale (X), et où les puces à semi-conducteurs de puissance (100) du deuxième sous-ensemble sont disposées le long d'un deuxième chemin (100-B) parallèle au premier chemin (100-A) et décalé horizontalement par rapport à celui-ci.

10. Boîtier (200) selon la revendication 9, dans lequel la structure de grille de connexion comprend une première barre de bornes de charge supplémentaire (211), et où :
- la première barre de bornes de charge (211) s'étend le long de la première direction latérale (X) de manière à établir ultérieurement un contact électrique avec les premières bornes de charge (101) des puces à semi-conducteurs de puissance (100) du premier sous-ensemble ; et
- la première barre de bornes de charge supplémentaire (211) s'étend le long de la première direction latérale (X) de manière à établir ultérieurement un contact électrique avec les premières bornes de charge (101) des puces à semi-conducteurs de puissance (100) du deuxième sous-ensemble.

11. Système (1000) pour fournir un courant de charge à une charge (500), le système (1000) comprenant :
- une alimentation électrique (400) ;
- un chemin d'alimentation électrique (600) pour coupler l'alimentation électrique (400) à la charge (500) ;
- un interrupteur principal du système (700) situé sur le chemin d'alimentation électrique (600), où l'interrupteur principal du système (700) comprend un ou plusieurs boîtiers (200) de l'une des revendications précédentes, où les un ou plusieurs boîtiers (200) sont configurés pour conduire le courant de charge.
